# EUROPÄISCHE PATENTSCHRIFT

(11) **EP 1 860 740 B1**
(45) Veröffentlichungstag und Bekanntmachung des Hinweises auf die Patenterteilung: **12.01.2011**
(21) Anmeldenummer: 06010699.4
(22) Anmeldetag: 23.05.2006
(51) Int. Cl.: H01R 13/24, H05K 3/34, H01L 33/00

(54) **Elektronisches Bauteil mit Kontaktelementen**
Electronic component with contact elements
Composant électronique avec des contacts

(43) Veröffentlichungstag der Anmeldung: 28.11.2007
(73) Patentinhaber: Delphi Technologies, Inc., Troy, Michigan 48007 (US)
(72) Erfinder: Hombach, Frank, 51674 Wiehl (DE); Hupertz, Stefan, 57462 Olpe (DE); Noll, Diethelm, 57589 Birkenbeul (DE)
(74) Vertreter: Denton, Michael John

(56) Entgegenhaltungen:
- DE-A1- 3 524 138
- FR-A- 2 784 806
- US-A- 5 900 738
- US-A1- 2005 048 807
- US-B1- 6 741 085

## Beschreibung

Die vorliegende Erfindung betrifft ein elektronisches Bauteil mit Kontaktelementen, insbesondere zur Kontaktierung des Bauteils mit einer Leiterplatte.

Bei der Herstellung elektronischer Schaltungen kann es vorkommen, dass elektronische Bauteile mit einer Leiterplatte zu kontaktieren sind, wobei die Bauteile nicht direkt auf der Leiterplatte angeordnet sein sollen. Üblicherweise werden derartige Bauteile mittels flexibler Kabel mit der Leiterplatte verbunden. Ein solches Bauteil kann zum Beispiel eine Leuchtdiode (LED) sein, die elektrisch mit der Leiterplatte verbunden sein soll, mechanisch aber an einem beabstandet von der Leiterplatte angeordneten Gehäuse befestigt ist.

Die Kontaktierung vorstehend beschriebener Bauteile mit Kabeln an einer Leiterplatte gestaltet sich oftmals schwierig. So müssen die zu kontaktierenden Enden der Kabel aufwändig an die bestimmungsgemäße Position auf der Leiterplatte gebracht und während des Lötvorgangs dort gehalten werden. Ein solcher Befestigungsvorgang ist zeitraubend und arbeitsintensiv und somit auch kostspielig.

Aus der US 2002/0089064 sind elektronische Bauteile bekannt, die nicht direkt auf einer Leiterplatte befestigt werden. Um Beschädigungen der Kontaktierung aufgrund von Temperatur- oder Biegeverformungen der Leiterplatte zu verhindern, sind flexible Verbindungen zwischen einem elektronischen Bauelement und der Leiterplatte vorgesehen. Somit ist das elektronische Bauteil in einem geringen Abstand von der Leiterplatte angeordnet und Verformungen der Leiterplatte führen nicht dazu, dass das Bauteil beschädigt wird.

Die Dokumente FR 2 784 806 A1, US 5,900,738 A und US 6,741,085 B offenbaren jeweils ein elektronisches Bauteil sowie ein Verfahren zum Befestigen des elektronischen Bauteils an einer Leiterplatte, bei dem sich die Kontaktelemente des elektronischen Bauteils in zumindest teilweise gefaltetem Zustand befinden.

Die Druckschrift US 5,900,738 A offenbart zudem Fixierungselemente, mit denen das elektronische Bauteil an der Leiterplatte fixiert werden kann.

Der Erfindung liegt die Aufgabe zugrunde, ein elektronisches Bauteil zu schaffen, das auf einfache und kostengünstige Weise zuverlässig mit einer Leiterplatte verbindbar ist, wobei das elektronische Bauteil nicht selbst auf der Leiterplatte befestigt werden soll. Vielmehr soll es möglich sein, das Bauteil beabstandet von der Leiterplatte, mit der es kontaktiert ist, anzuordnen. Weiterhin soll ein Verfahren geschaffen werden, um ein elektronisches Bauteil mit einer Leiterplatte zu kontaktieren.

Die Lösung dieser Aufgaben erfolgt durch die Merkmale der unabhängigen Ansprüche.

Das erfindungsgemäße elektronische Bauteil nach Anspruch 1 zeichnet sich dadurch aus, dass es Kontaktelemente aufweist, die zumindest abschnittsweise in ihrem Verlauf mehrere Abwinklungen aufweisen. Die Abwinklungen sind derart ausgebildet, dass die Kontaktelemente zumindest abschnittsweise faltbar sind. Die Kontaktelemente sind aus einem gefalteten Zustand in einer Hauptentfaltungsrichtung entfaltbar. Die Hauptentfaltungsrichtung erstreckt sich im Wesentlichen senkrecht zu einer Montagefläche der Leiterplatte, das heißt im Wesentlichen senkrecht zu der Fläche der Leiterplatte, an der der Kontakt zwischen den Kontaktelementen des elektronischen Bauteils mit der Leiterplatte hergestellt werden soll. Dadurch ist es möglich, dass das elektronische Bauteil in einem gewünschten Abstand von der Montageoberfläche positionierbar ist. Darüber hinaus weist des elektronische Bauteil ein Fixierungselement auf, um einen gefalteten Zustand des Kontaktelemente zu sichern.

Mit anderen Worten kann je nach Grad der Entfaltung der Kontaktelemente eine bestimmte Position in einem Abstand von der Leiterplatte durch das elektronische Bauteil eingenommen werden, wobei eine zuverlässige Kontaktierung mit der Leiterplatte trotzdem gewährleistet ist.

In einem gefalteten Zustand sind die Kontaktelemente des elektronischen Bauteils kompakt angeordnet. Dies erleichtert wesentlich die Positionierung des Bauteils bei der Montage. Frei bewegliche Kabel, wie sie bisher verwendet wurden, sind demgegenüber schwieriger an den vorbestimmten Kontaktpunkten zu fixieren.

Vorteilhafte Ausführungsformen der Erfindung sind in den Unteransprüchen, der Beschreibung und den Zeichnungen angegeben.

Gemäß einer Ausführungsform des elektronischen Bauteils ist der faltbare Abschnitt der Kontaktelemente zieharmonika-, spiral- oder wendelartig ausgebildet. Beispielsweise kann der faltbare Abschnitt auch einen zickzackartigen Verlauf haben. Derartige Ausbildungen der Kontaktelemente sind besonders kompakt und technisch leicht zu realisieren. Außerdem kann damit eine reproduzierbare Faltbarkeit der Kontaktelemente erreicht werden.

In einer weiteren Ausführungsform erstrecken sich die Kontaktelemente in einem gefalteten Zustand zumindest abschnittsweise im Wesentlichen in einer Ebene parallel zu der Leiterplatte. Das heißt die Kontaktelemente werden derart gefaltet, dass sie in einer Hauptentfaltungsrichtung senkrecht zur Montageoberfläche eine geringe Erstreckung aufweisen. Dies erleichtert die Positionierung bei der Montage des elektronischen Bauteils. Während der Positionierung befinden sich die Kontaktelemente, wie vorstehend ausgeführt, in einem gefalteten Zustand.

Die Kontaktelemente können federnd ausgebildet sein. Insbesondere der faltbare Abschnitt der Kontaktelemente kann diese Eigenschaft aufweisen. Dadurch wird eine kontrollierte Führung der Kontaktelemente erreicht, da die Kontaktelemente dazu neigen entweder einen entfalteten oder einen gefalteten Zustand einzunehmen. Je nach Anforderung kann es also erwünscht sein, dass das elektronische Bauteil durch die Wirkung der federnd ausgebildeten Kontaktelemente dazu neigt, sich ohne Einwirkung äußerer Kräfte auf die Leiterplatte zurückzuziehen bzw. von dieser abgestoßen zu werden.

Es ist vorgesehen, dass das elektronische Bauteil zumindest ein Fixierungselement aufweist, um einen gefalteten Zustand der Kontaktelemente zu sichern. Das Fixierungselement kann lösbar mit dem elektronischen Bauteil verbunden sein, damit es nach der Montage des Bauteils entfernt werden kann. Derartige Fixierungselemente können beispielsweise Klammem oder Clips sein. Es kann aber auch vorgesehen sein, dass die Fixierungselemente nach Montage des elektronischen Bauteils an diesem befestigt bleiben, um gegebenenfalls nochmals verwendet zu werden und eine wiederholte Sicherung des gefalteten Zustands zu ermöglichen. Solche Fixierungselemente zur Sicherung des gefalteten Zustands erleichtern die Aufbewahrung und Montage des erfindungsgemäßen Bauteils.

Gemäß einer weiteren Ausführungsform des elektronischen Bauteils ist zwischen dem Bauelement des elektronischen Bauteils und den Kontaktelementen ein Leiterplattenabschnitt angeordnet. Mit anderen Worten ist das elektronische Bauteil, wie zum Beispiel eine Leucht- oder Fotodiode, auf einem Leiterplattenabschnitt angebracht. Dieser wiederum weist die vorstehend beschriebenen Kontaktelemente auf, welche mit der Montagefläche der Leiterplatte verbunden sind. Auf dem Leiterplattenabschnitt können auch mehrere Bauelemente angeordnet sein.

Das elektronische Bauteil kann ein oder mehrere Verbindungselemente aufweisen, die an dem elektronischen Bauteil befestigt sind. Mit derartigen Verbindungselementen kann das elektronische Bauteil an seiner bestimmungsgemäßen Position, beispielsweise an einem Gehäuse, befestigt werden.

Gemäß einer vorteilhaften Ausführungsform des erfindungsgemäßen elektronischen Bauteils ist das Bauteil bei zumindest teilweisem Entfalten der Kontaktelemente in einem Abstand von der Montagefläche positionierbar, der größer ist als der Abstand zwischen Kontaktstellen der Kontaktelemente mit der Leiterplatte. Mit anderen Worten kann das elektronische Bauteil also deutlich beabstandet von der Leiterplatte angeordnet werden, mit der das Bauteil kontaktiert ist.

Die Erfindung betrifft weiterhin ein Verfahren nach Anspruch 7 zum Kontaktieren eines elektronischen Bauteils mit einer Leiterplatte, wobei ein elektronisches Bauteil nach einer der vorstehend beschriebenen Ausführungsformen verwendet wird.

Die Erfindung wird im Folgenden rein beispielhaft anhand vorteilhafter Ausführungsformen und unter Bezugnahme auf die Zeichnungen beschrieben. Es zeigen:
- Fig. 1: ein elektro- nisches Bauteil,
- Fig. 2: ein erfindungsgemãßes elektronisches Bauteil, wobei sich die Kontaktelemente in einem gefalteten Zustand befinden,
- Fig. 3: ein elektronisches Bauteil in mon- tiertem Zustand mit teilweise entfalteten Kontaktele- menten,
- Fig. 4: eine weitere Ausführungsform eines elektronischen Bauteils in montiertem Zustand.

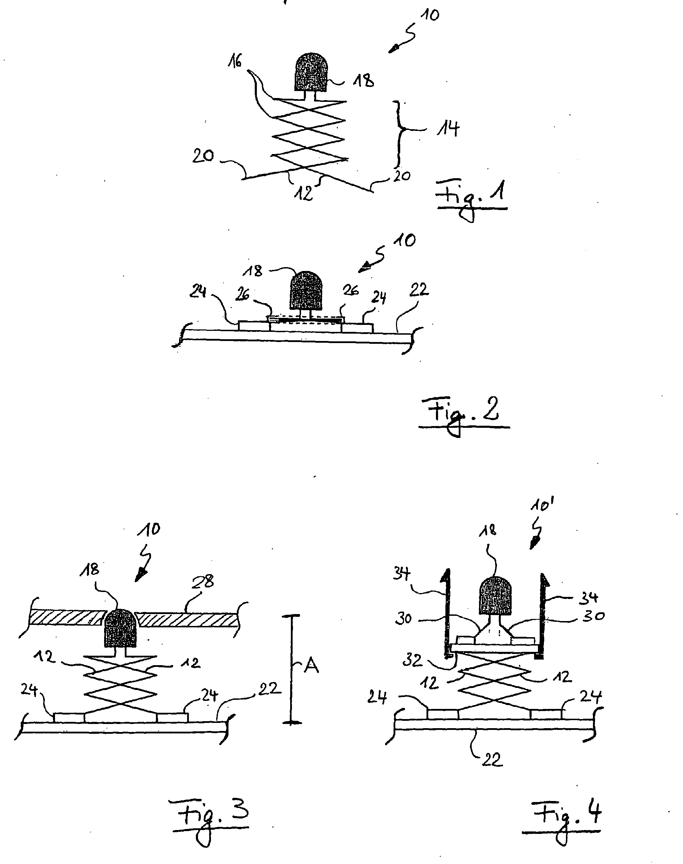

Fig. 1 zeigt schematisch ein elektronisches Bauteil 10. Das Bauteil 10 umfasst zwei Kontaktelemente 12, die einen faltbaren Abschnitt 14 aufweisen. In dieser einfachen Ausgestaltung der Kontaktelemente 12 umfassen diese jeweils vier Abwinklungen 16 in dem Bereich des faltbaren Abschnitts 14. In der dargestellten Ausführungsform ist der faltbare Abschnitt 14 der Kontaktelemente 12 ziehharmonikaartig ausgebildet. Andere Ausführungsformen können beispielsweise spiral- oder wendelförmige faltbare Abschnitte 14 der Kontaktelemente 12 aufweisen. Das elektronische Bauteil 10 weist überdies ein elektronisches Bauelement 18 auf. Dies kann beispielsweise eine Leuchtdiode (LED), eine Fotodiode, eine Laserdiode (LD) oder ein anderes Halbleiterelement sein. Die freien Enden der Kontaktelemente 12 sind als Kontaktabschnitte 20 ausgebildet und dienen der Kontaktierung des elektronischen Bauteils 10 mit einer Leiterplatte.

Fig. 2 zeigt das in Fig. 1 dargestellte elektronische Bauteil 10 in einem montierten Zustand auf einer Leiterplatte 22. Die Kontaktabschnitte 20 erstrecken sich innerhalb der Kontaktpunkte 24, die den elektrischen Kontakt zwischen der Leiterplatte 22 und dem Bauelement 18 über die leitfähigen Kontaktelemente 12 sicherstellen und das elektronische Bauteil 10 fixieren. Der faltbare Abschnitt 14 der Kontaktelemente 12 befindet sich in einem gefalteten Zustand. Das heißt die Kontaktelemente 12 erstrecken sich im Wesentlichen in einer Ebene parallel zu der Leiterplatte 22. Dieser gefaltete Zustand wird durch Sicherungsklammern 26 gegen Entfalten gesichert. In diesem Zustand, das heißt mit gefalteten Kontaktelementen 12, wird bei der Montage das elektronische Bauteil 10 an seinem bestimmungsgemäßen Ort auf der Leiterplatte 22 aufgebracht. In dem gefalteten Zustand lassen sich die Kontaktabschnitte 20 exakt an den geeigneten Positionen ausrichten. Die Kontaktabschnitte 20 werden anschließend mit der Leiterplatte 22 verbunden, insbesondere verlötet. Bei elektrischen Bauteilen mit frei beweglichen Kabeln, wie sie bisher verwendet wurden, ist die Positionierung der Kabelenden auf der Leiterplatte 22 wesentlich aufwändiger.

Die in Fig. 2 dargestellten Sicherungsklammern 26 sind lösbar mit dem elektronischen Bauteil 10 verbunden und können nach der Montage des elektronischen Bauteils 10 entfernt werden. Andere Ausführungsformen des elektronischen Bauteils 10 können Fixierungselemente aufweisen, die nach Montage mit dem elektronischen Bauteil 10 verbunden bleiben, um später eine erneute Sicherung des gefalteten Zustands zu ermöglichen.

In Fig. 3 ist das elektronische Bauteil 10 in einem endmontierten Zustand zu sehen. Die Kontaktabschnitte 20 sind an den Kontaktpunkten 24 mit der Leiterplatte 22 elektrisch leitend befestigt. Der faltbare Abschnitt 14 ist zumindest teilweise entfaltet, wobei die Entfaltung im Wesentlichen in einer Richtung senkrecht zu der Oberfläche der Leiterplatte 22 (Montageoberfläche) erfolgt. Die Flächennormale der Oberfläche der Leiterplatte 22, auf der das elektronische Bauteil 10 montiert ist, stellt also die Hauptentfaltungsrichtung der Kontaktelemente 12 dar. Das Bauelement 18 ist an einem Gehäuse 28 befestigt.

Das elektronische Bauelement 18 ist in dem endmontierten Zustand von der Leiterplatte 22 durch einen Abstand A getrennt. Insbesondere kann der Abstand A größer sein als der Abstand der Kontaktpunkte 24. Durch die vorteilhafte Ausgestaltung der Kontaktelemente 12 kann der Abstand A variieren und frei gewählt werden. Die Variationsbreite des Abstands A hängt von der Ausgestaltung der Kontaktelemente 12 ab, das heißt welche maximale Länge die Kontaktelemente 12 bei vollständiger Entfaltung/Streckung erreichen können. Dadurch ist bei geeigneter Ausgestaltung der Kontaktelemente 12 das elektronische Bauteil 10 in einer Vielzahl von Anwendungen einsetzbar. Außerdem wirken sich variable Abstände A, zum Beispiel hervorgerufen durch Vibrationen der Leiterplatte 22 bzw. des Gehäuses 28, nicht negativ auf die Kontaktierung des elektronischen Bauteils 10 aus.

Der faltbare Abschnitt 14 kann auch federnd ausgestaltet sein, so dass zum Beispiel nach Lösen der Sicherungsklammern 26 das Bauelement 18 von der Leiterplatte "springt". Anschließend kann es leicht an dem Gehäuse 28 angebracht werden. Der umgekehrte Fall kann ebenso vorgesehen sein. In diesem Fall sind die Kontaktelemente 12 derart ausgestaltet, dass die Federwirkung das Bauelement 18 in der Nähe der Leiterplatte 22 hält. Erst durch Anwendung einer entgegengesetzt wirkenden Kraft, zum Beispiel in einer Richtung senkrecht zur Oberfläche der Leiterplatte 22, kann das Bauelement 18 von der Leiterplatte entfernt werden und an der bestimmungsgemäßen Position verankert werden.

Fig. 4 zeigt eine weitere Ausführungsform eines elektronischen Bauteils 10'. Das Bauelement 18 ist mit Kontaktdrähten 30 mit einem Leiterplattenabschnitt 32 verbunden. Der Leiterplattenabschnitt 32 ist wiederum mit Kontaktelementen 12 kontaktiert, die beispielsweise wie vorstehend beschrieben ausgestaltet sind. Die Kontaktelemente 12 sind wiederum an den Kontaktpunkten 24 mit der Leiterplatte 22 verbunden.

Das Bauelement 18 bildet also mit dem Leiterplattenabschnitt 32 und den Kontaktdrähten 30 eine Einheit, die beispielsweise mit Rastarmen 34 oder anderen geeigneten Befestigungsmitteln oder Verbindungselementen an einem Gehäuse 28 befestigt werden kann. Diese Einheit kann auch mehrere verschiedene Bauelemente 18 umfassen und somit einen komplexen Aufbau aufweisen, wobei die vorstehend beschriebenen Vorteile der faltbaren Ausgestaltung der Kontaktelemente 12 trotzdem genutzt werden können.

Die beschriebenen elektronischen Bauelemente 10, 10' sind also in einem gefalteten Zustand leicht auf der Leiterplatte zu positionieren und zu kontaktieren. Durch ein anschließendes teilweises Entfalten der Kontaktelemente kann das elektronische Bauteil 10, 10' beabstandet von einer Montagefläche der Leiterplatte 22 positioniert und/oder angebracht werden. Der Abstand zwischen der Leiterplatte 22 und dem Bauelement 18 kann variabel sein. Relativbewegungen zwischen einem Fixierungspunkt des Bauelements 18 und den Kontaktpunkten 24 führen daher nicht zu schädigenden mechanischen Belastungen der Kontaktierung.

Ein Verfahren zur Kontaktierung des elektronischen Bauteils 10 (oder auch 10') umfasst als ersten Schritt eine Bereitstellung eines solchen Bauteils 10, 10' in einem Montagezustand. In dem Montagezustand sind die Kontaktelemente 12 des elektronischen Bauteils 10, 10' gefaltet. Anschließend wird das Bauteil 10, 10' an dem Ort auf der Leiterplatte 22 positioniert, an dem es kontaktiert werden soll. Währendessen befinden sich die Kontaktelemente 12 weiterhin in dem gefalteten Zustand. Nach erfolgter Kontaktierung werden die Sicherungsklammern 26 gelöst (wenn vorhanden) und die Kontaktelemente 12 zumindest teilweise entfaltet. Daraufhin wird das Bauelement 18 des elektronischen Bauteils 10, 10' an seine bestimmungsgemäße Position gebracht, die sich in dem Abstand A von der Oberfläche der Leiterplatte 22 befindet. Gegebenenfalls wird dann das elektronische Bauteil 10, 10' an dem Gehäuse 28 befestigt.

### Bezugszeichenliste

- 10, 10': elektronisches Bauteil
- 12: Kontaktelement
- 14: faltbarer Abschnitt
- 16: Abwinklung
- 18: Bauelement
- 20: Kontaktabschnitt
- 22: Leiterplatte
- 24: Kontaktpunkt
- 26: Sicherungsklammer
- 28: Gehäuse
- 30: Kontaktdraht
- 32: Leiterplattenabschnitt
- 34: Rastarm

- A: Abstand

## Patentansprüche

1. Elektronisches Bauteil mit Kontaktelementen (12) und einem Fixierungselement (26), wobei die Kontaktelemente (12) dazu dienen das Bauteil mit einer Leiterplatte (22) zu kontaktieren, wobei die Kontaktelemente (12) zumindest abschnittsweise in ihrem Verlauf mehrere Abwinklungen (16) aufweisen, die so ausgebildet sind, dass die Kontaktelemente (12) zumindest abschnittsweise derart faltbar sind, dass sie aus dem gefalteten Zustand in einer Hauptentfaltungsrichtung entfaltbar sind, damit das elektronische Bauteil beabstandet von einer Montageoberfläche der Leiterplatte (22) positionierbar ist, wobei sich die Hauptentfaltungsrichtung im Wesentlichen senkrecht zu einer Montagefläche der Leiterplatte (22) erstreckt, **dadurch gekennzeichnet, dass**
das Fixierungselement (26) dazu dient, einen gefalteten Zustand der Kontaktelemente (12) zu sichern.

2. Elektronisches Bauteil nach Anspruch 1,
**dadurch gekennzeichnet, dass**
der faltbare Abschnitt (14) der Kontaktelemente (12) ziehharmonika-, spiral- oder wendelartig ausgebildet ist.

3. Elektronisches Bauteil nach zumindest einem der vorstehenden Ansprüche,
**dadurch gekennzeichnet, dass**
die Kontaktelemente (12) federnd ausgebildet sind.

4. Elektronisches Bauteil nach Anspruch 1,
**dadurch gekennzeichnet, dass**
das Fixierungselement (26) lösbar mit dem elektronischen Bauteil verbunden ist.

5. Elektronisches Bauteil nach zumindest einem der vorstehenden Ansprüche,
**dadurch gekennzeichnet, dass**
zwischen einem Bauelement (18) des elektronischen Bauteils und den Kontaktelementen (12) ein Leiterplattenabschnitt (32) angeordnet ist.

6. Elektronisches Bauteil nach zumindest einem der vorstehenden Ansprüche,
**dadurch gekennzeichnet, dass**
an dem elektronischen Bauteil zumindest ein Verbindungselement (34) befestigt ist.

7. Verfahren zum Kontaktieren eines elektronischen Bauteils mit einer Leiterplatte in den Schritten:
Bereitstellen des elektronischen Bauteils nach zumindest einem der vorstehenden Ansprüche, wobei sich die Kontaktelemente (12) des elektronischen Bauteils in einem gefalteten Zustand befinden;
Positionieren der in gefaltetem Zustand befindlichen Kontaktelemente (12) auf der Leiterplatte;
Kontaktieren der Kontaktelemente (12) mit Kontakten der Leiterplatte (22);
zumindest teilweises Entfalten der Kontaktelemente (12); und
Positionieren des elektronischen Bauteils beabstandet von einer Montagefläche der Leiterplatte (22).

## Claims

1. Electronic component with contact elements (12) and a fixing element (26), the contact elements (12) for contacting the component with a printed circuit board (22), wherein the contact elements (12) comprise several bendings (16) at least in sections in their course, which are formed so that the contact elements (12) at least in sections are foldable such that they can be unfolded from the folded state in a main unfolding direction, so that the electronic component can be positioned spaced apart from a mounting surface of the printed circuit board (22), wherein the main unfolding direction extends essentially perpendicular to a mounting surface of the printed circuit board (22),
**characterized in that** the fixing element (26) serves to secure a folded state of the contact elements (12).

2. Electronic component according to claim 1,
**characterized in that** the foldable section (14) of the contact elements (12) is formed accordion-like, spirally or helically.

3. Electronic component according to at least one of the preceding claims, **characterized in that** the contact elements (12) are formed resilient.

4. Electronic component according to claim 1,
**characterized in that** the fixing element (26) is connected releasably with the electronic component.

5. Electronic component according to at least one of the preceding claims,
**characterized in that** a printed circuit board section (32) is disposed between an element (18) of the electronic component and the contact elements (12).

6. Electronic component according to at least one of the preceding claims,
**characterized in that** at least a connecting element (34) is attached to the electronic component.

7. Method for contacting an electronic component with a printed circuit board, having the steps:
providing the electronic component according to at least one of the preceding claims, wherein the contact elements (12) of the electronic component are in a folded state;
positioning the folded contact elements (12) on the printed circuit board;
contacting the contact elements (12) with contacts of the printed circuit board (22);
at least partially unfolding the contact elements (12); and
positioning the electronic component spaced apart from a mounting surface of the printed circuit board (22).

## Revendications

1. Composant électronique comprenant des éléments de contact (12) et un élément de fixation (26), dans lequel les éléments de contact (12) servent à mettre le composant en contact avec une carte à circuits imprimés (22), dans lequel les éléments de contact (12) présentent au moins sur des tronçons de leurs tracés plusieurs coudages (16) qui sont réalisés de telle manière que les éléments de contact (12) peuvent être repliés au moins par tronçons et de telle manière qu'ils peuvent être dépliés à partir de leur état plié dans une direction de déploiement principale afin de pouvoir positionner le composant électronique à distance d'une surface de montage de la carte à circuits imprimés (22), ladite direction de déploiement principale s'étendant sensiblement perpendiculairement à une surface de montage de la carte à circuits imprimés (22),
**caractérisé en ce que** l'élément de fixation (26) sert à bloquer un état déployé des éléments de contact (12).

2. Composant électronique selon la revendication 1,
**caractérisé en ce que** le tronçon pliable (14) des éléments de contact (12) est réalisé en forme d'accordéon, de spirale ou d'hélice.

3. Composant électronique selon l'une au moins des revendications précédentes,
**caractérisé en ce que** les éléments de contact (12) sont réalisés avec effet ressort.

4. Composant électronique selon la revendication 1,
**caractérisé en ce que** l'élément de fixation (26) est relié de façon détachable au composant électronique.

5. Composant électronique selon l'une au moins des revendications précédentes,
**caractérisé en ce qu'**un tronçon de carte à circuits imprimés (32) est agencé entre un élément structurel (18) du composant électronique et les éléments de contact (12).

6. Composant électronique selon l'une au moins des revendications précédentes,
**caractérisé en ce qu'**au moins un élément de liaison (34) est fixé sur le composant électronique.

7. Procédé pour mettre en contact un composant électronique avec une carte à circuits imprimés, comprenant les étapes consistant à :
préparer le composant électronique selon l'une au moins des revendications précédentes, de sorte que les éléments de contact (12) du composant électronique se trouvent dans un état plié ;
positionner les éléments de contact (12) qui se trouvent dans l'état plié, sur la carte à circuits imprimés ;
mise en contact des éléments de contact (12) avec des contacts de la carte à circuits imprimés (22) ;
déploiement au moins partiel des éléments de contact (12) ; et
positionnement du composant électronique à distance d'une surface de montage de la carte à circuits imprimés (22).
